Europäisches Patentamt

European Patent Office

Office européen des brevets

(19)

(11) Numéro de publication : **0 174 220 B1**

(12) **FASCICULE DE BREVET EUROPÉEN**

(45) Date de publication du fascicule du brevet :
**17.05.89**

(51) Int. Cl.⁴ : **G 01 R 31/28**

(21) Numéro de dépôt : **85401443.8**

(22) Date de dépôt : **15.07.85**

(54) **Système de test de la défaillance ou du bon fonctionnement d'un circuit à composants logiques.**

(30) Priorité : **18.07.84 FR 8411388**

(43) Date de publication de la demande :
**12.03.86 Bulletin 86/11**

(45) Mention de la délivrance du brevet :
**17.05.89 Bulletin 89/20**

(84) Etats contractants désignés :
**BE DE GB IT NL**

(56) Documents cités :
**EP—A— 0 060 194**

(73) Titulaire : **COMMISSARIAT A L'ENERGIE ATOMIQUE
31/33, rue de la Fédération
F-75015 Paris (FR)**

(72) Inventeur : **Laviron, André
15, rue des Champs Viaux Daix
F-21121 Fontaine les Dijon (FR)**

(74) Mandataire : **Mongrédien, André et al
c/o BREVATOME 25, rue de Ponthieu
F-75008 Paris (FR)**

Jouve, 18, rue St-Denis, 75001 Paris, France

**Description**

La présente invention concerne un système de test de la défaillance ou du bon fonctionnement d'un circuit à composants logiques dans lequel n composants forment un ensemble de composants repérés de 1 à n de manière prédéterminée. Ces composants sont reliés entre eux pour que cet ensemble présente, sur une sortie, un état logique qui dépend de l'état de défaillance ou de fonctionnement de l'ensemble et qui dépend de l'état de défaillance ou de bon fonctionnement de chacun des n composants de l'ensemble. Chacun des composants de l'ensemble présente au moins une entrée de simulation qui est apte à recevoir un signal de simulation de la défaillance ou du bon fonctionnement de ce composant.

Ce système de test peut permettre l'étude de circuits électroniques comprenant une pluralité de composants logiques, mais il peut permettre, par analogie, l'étude de la défaillance ou du bon fonctionnement d'un circuit hydraulique par exemple, dont un ou plusieurs composants peuvent être en état de défaillance ou de bon fonctionnement ; dans ce cas, le circuit hydraulique est remplacé par un circuit électronique comprenant une pluralité de composants logiques dont le fonctionnement est équivalent, par analogie, à celui des composants correspondants du circuit hydraulique.

Généralement, un circuit constitué de composants logiques présente une sortie dont l'état logique dépend de l'état de défaillance ou de bon fonctionnement de chacun de ses composants. Ce circuit peut être, comme on l'a mentionné plus haut, soit un circuit réel, soit un circuit simulant un circuit à étudier. Chacun des composants présente généralement une entrée qui est reliée à une sortie d'un autre composant du circuit et une autre entrée qui peut recevoir un signal de simulation de la défaillance ou du bon fonctionnement de ce composant.

Les systèmes qui permettent de tester des circuits de ce type sont généralement compliqués et coûteux, difficiles à mettre en œuvre ; ils sont généralement constitués par un calculateur qui est relié au circuit à tester par l'intermédiaire d'une interface spécifique à chaque circuit. Ce type de système nécessite un programme de traitement particulier à chaque circuit et il en résulte que les tests effectués peuvent présenter une durée importante.

Dans les tests de circuits constitués de composants logiques, l'homme de l'art a coutume d'utiliser un certain nombre de termes qui sont les suivants :

— La coupe d'un circuit est l'ensemble de tous les repères des composants défaillants de ce circuit, tels que si tous ces composants sont défaillants, le circuit est défaillant, les autres composants de ce circuit, qui ne font pas partie de la coupe, étant en bon fonctionnement,

— Le lien d'un circuit est l'ensemble de tous les repères des composants en bon fonctionnement de ce circuit, tels que si tous ces composants sont en bon fonctionnement, le circuit est en bon fonctionnement, tous les autres composants du circuit qui ne font pas partie du lien étant défaillants,

— L'ordre d'une coupe ou d'un lien est constitué par le nombre de repères des composants respectivement défaillants ou en bon fonctionnement qui décrivent la coupe ou le lien,

— La coupe minimale est une coupe telle qu'il est impossible de trouver une autre configuration, en supprimant un ou plusieurs éléments défaillants parmi ceux dont les repères décrivent la coupe et qui permettraient de maintenir le circuit en état de défaillance,

— un lien minimal est un lien tel qu'il est impossible de trouver une autre configuration, en supprimant un ou plusieurs composants en bon fonctionnement, parmi ceux dont les repères décrivent le lien et qui permettraient de maintenir le circuit en état de bon fonctionnement,

— La coupe minimale par rapport à l'ordre précédent est une coupe telle qu'il n'est pas possible de trouver une autre configuration de cette coupe, en supprimant un seul composant défaillant, parmi ceux dont les repères décrivent la coupe, tout en maintenant le circuit en état de défaillance,

— de la même manière, un lien minimal par rapport à l'ordre précédent est un lien tel qu'il n'est pas possible de trouver une autre configuration de ce lien en supprimant un seul composant en bon fonctionnement parmi ceux dont les repères décrivent le lien, tout en maintenant le circuit en état de bon fonctionnement.

Lorsque tous les composants qui décrivent une coupe d'un circuit sont défaillants, le circuit est défaillant.

On définit alors un état de défaillance critique d'un circuit, un ou des composants critiques dans un état de défaillance critique, ainsi qu'une coupe critique.

L'état de défaillance critique d'un circuit ou d'un système est un état de défaillance de ce circuit ou système, tel qu'il existe au moins un composant décrivant une coupe de ce circuit ou système, qui, lorsqu'il est réparé remet le circuit en état de bon fonctionnement.

Un composant critique d'un état de défaillance critique est un composant qui décrit la coupe correspondante et qui, lorsqu'il est réparé permet de remettre le circuit en état de bon fonctionnement (ce composant étant le seul à être réparé à un instant donné).

Il est à remarquer qu'il peut donc y avoir plusieurs composants critiques pour une même coupe et qu'un état de défaillance qui correspond à une coupe ne contenant que des composants critiques permet de déduire que la coupe est minimale par rapport à l'ordre précédent.

Une coupe critique est une coupe qui correspond à un état de défaillance critique du circuit ou du système. On peut, de la même manière, définir un état de bon fonctionnement critique d'un système ou d'un circuit, un ou des composants critiques dans un état de défaillance critique, ainsi qu'un lien critique :

— l'état de bon fonctionnement critique d'un circuit ou d'un système est un état de bon fonctionnement de ce circuit ou système, tel qu'il existe au moins un composant décrivant un lien de ce circuit ou système, qui, lorsqu'il est mis en état de défaillance met le circuit ou système en état de défaillance,

— un composant critique d'un état de bon fonctionnement critique d'un circuit ou système est donc un composant qui décrit un lien de ce circuit ou système qui, lorsqu'il est mis en état de défaillance, permet de mettre le circuit en état de défaillance (ce composant étant le seul à être mis en état de défaillance à un instant donné).

Il est à remarquer qu'il peut y avoir plusieurs composants critiques pour un même lien et qu'un état de bon fonctionnement qui correspond à un lien ne contenant que des composants critiques, permet de déduire que le lien est minimal par rapport à l'ordre précédent.

Un lien critique est un lien qui correspond à un état de bon fonctionnement critique du circuit ou du système.

On peut enfin définir un circuit ou système non cohérent : c'est un circuit ou système dans lequel on peut trouver des états de défaillance tels qu'en rajoutant un ou plusieurs composants en état de panne ou défaillance à ce circuit ou système, celui-ci est remis en état de bon fonctionnement. Le composant est alors qualifié de non cohérent.

En plus des inconvénients mentionnés plus haut (coût, complexité, difficulté de mise en œuvre), les systèmes de test connus ne permettent pas, de façon simple, de déterminer si une coupe ou un lien est minimal par rapport à l'ordre précédent. Seul le système décrit dans la demande de brevet Français (correspondant à la demande de brevet Europeen EP-A-0 060 194) n° 8104868 déposée le 11 mars 1981 au nom du même demandeur, permet de déterminer si une coupe ou un lien est minimal par rapport à l'ordre précédent, dans le cas de systèmes très complexes.

Ce système ainsi que les autres systèmes connus qui utilisent notamment des calculateurs, ne permettent toutefois pas de déterminer un état de défaillance ou de bon fonctionnement critique pour les systèmes complexes, si une coupe ou un lien est critique et quel est le ou les composants critiques dans cette coupe ou ce lien critique. Ces systèmes ne permettent pas non plus de déterminer si un circuit ou un système pour les systèmes complexes est non cohérent et quel est le ou les composants non cohérents.

L'invention a pour but de remédier à ces inconvénients en réalisant un système permettant d'effectuer des tests de manière rapide, simple, peu coûteuse et efficace, sur des circuits pour lesquels on a déterminé une coupe ou un lien et pour lesquels on recherche alors si cette coupe ou ce lien est critique, et quel est ou quels sont, dans cette coupe ou ce lien, le ou les composants critiques. L'invention permet aussi de déterminer si un circuit ou système est non cohérent.

L'invention a pour objet un système de test de la défaillance ou de bon fonctionnement d'un circuit à composants logiques, dans lequel n composants forment un ensemble de composants repérés de 1 à n de manière prédéterminée et reliés entre eux pour que cet ensemble présente sur une sortie, un état logique qui correspond à l'état de défaillance ou au bon fonctionnement de l'ensemble, et qui dépend de l'état de défaillance ou de bon fonctionnement de chacun des n composants de l'ensemble, chacun des n composants de l'ensemble présentant au moins une entrée de simulation apte à recevoir un signal de simulation de la défaillance ou du bon fonctionnement de ce composant, comprenant :

— un générateur dont les sorties sont respectivement reliées aux entrées de simulation des composants pour leur appliquer des signaux de simulation présentant un premier ou un second état logique permettant de mettre un ou plusieurs composants, respectivement en état de défaillance ou de bon fonctionnement, puis de remettre inversement et réciproquement ce ou ces composants, en état de bon fonctionnement ou de défaillance, pour une ou plusieurs combinaisons parmi les n composants de l'ensemble,

— des moyens de test reliés à la sortie de l'ensemble et capables de repérer le niveau logique du signal de sortie de l'ensemble, caractérisé en ce que les moyens de test comprennent

— un compteur ayant une entrée de chargement d'une valeur prédéterminée correspondant aux nombres de composants à simuler dans le circuit testé, ce compteur ayant une autre entrée qui est reliée à la sortie du générateur fournissant un signal d'initialisation à l'initialisation du générateur, et une autre entrée qui est reliée à une sortie du générateur pour recevoir une impulsion de commande, cette impulsion commandant le décomptage de ce compteur, une sortie de ce compteur étant reliée à une entrée de commande d'arrêt du générateur pour arrêter ce générateur lorsque tous les composants ont été simulés,

— un autre compteur relié à une sortie du générateur pour recevoir un signal de remise à 0, à l'initialisation du générateur et une autre entrée qui est reliée à la sortie du générateur qui fournit chaque impulsion de commande, cette impulsion commandant l'incrémentation du contenu du compteur,

— des moyens de repérage du niveau logique du signal de sortie de l'ensemble, ces moyens de repérage étant reliés à la sortie de l'ensemble et à une sortie du générateur fournissant un signal de synchronisation pour chaque nouvelle combinaison de signaux de simulation, et à une sortie dudit autre compteur, pour repérer le numéro de tout composant pour lequel le changement de niveau logique du signal de simulation qui lui est appliqué, provoque un changement de niveau du signal de sortie de l'ensemble.

Selon une autre caractéristique, les moyens de repérage comprennent une porte ET ayant une entrée inversée reliée à la sortie de l'ensemble, et une autre entrée reliée à la sortie du générateur qui fournit ledit signal de synchronisation, et un moyen d'affichage de numéro dont une entrée est reliée à la sortie de la porte ET et dont une autre entrée est reliée à la sortie dudit autre compteur.

Selon une autre caractéristique, dans un ensemble de composants pour lesquels le générateur fournit des signaux dont le niveau logique correspond à la défaillance de ces composants et pour lesquels le signal de sortie de l'ensemble présente un niveau logique correspondant à la défaillance de cet ensemble, ce générateur fournissant ensuite successivement à chaque composant un signal dont le niveau logique correspond à son bon fonctionnement, les moyens d'affichage indiquent le ou les numéros des composants dits critiques pour lesquels la simulation d'un bon fonctionnement provoque un changement du niveau du signal de sortie de l'ensemble, qui correspond alors au bon fonctionnement de l'ensemble.

Selon une autre caractéristique, dans un ensemble de composants pour lesquels le générateur fournit des signaux dont le niveau logique correspond au bon fonctionnement de ces composants et pour lesquels le signal de sortie de l'ensemble présente un niveau logique correspondant au bon fonctionnement de cet ensemble, ce générateur fournissant ensuite successivement à chaque composant un signal dont le niveau logique correspond à sa défaillance, les moyens d'affichage indiquent le ou les numéros des composants dits critiques pour lesquels la simulation d'une défaillance provoque un changement du niveau du signal de sortie de l'ensemble, qui correspond alors à la défaillance de l'ensemble.

Selon une autre caractéristique, dans un ensemble de composants pour lesquels le générateur fournit à certains des composants des signaux dont le niveau logique correspond à la défaillance de ces composants et pour lesquels le signal de sortie de l'ensemble présente un niveau logique correspondant à la défaillance de cet ensemble, ce générateur fournissant ensuite à un ou d'autres composants de l'ensemble un signal dont le niveau logique correspond aussi à leur défaillance, les moyens d'affichage indiquent le ou les numéros de ce ou ces autres composants dits non cohérents pour lesquels la simulation d'une défaillance provoque un changement du niveau du signal de sortie de l'ensemble, qui correspond alors au bon fonctionnement de l'ensemble.

D'autres caractéristiques et avantages de l'invention ressortiront mieux de la description qui va suivre, donnés en référence aux dessins annexés dans lesquels :

— La figure 1A représente schématiquement un circuit hydraulique dont on veut étudier l'état de défaillance ou de bon fonctionnement en cas de défaillance ou de bon fonctionnement d'un ou de plusieurs de ses composants ; cette figure permet de mieux comprendre les définitions d'une coupe et d'un lien.

— La figure 1B représente schématiquement le circuit de la figure 1A dans lequel ont été rajoutés sur chacun des composants du circuit, des moyens permettant de simuler la défaillance ou le bon fonctionnement de chacun des composants,

— La figure 2A est un circuit logique équivalent au circuit hydraulique de la figure 1B et permettant d'étudier les coupes de ce circuit,

— La figure 2B est un circuit logique équivalent au circuit hydraulique de la figure 1B et permettant d'étudier les liens de ce circuit,

— La figure 2C représente schématiquement un exemple de circuit non cohérent,

— La figure 3 représente schématiquement le système conforme à l'invention et permettant d'étudier une coupe critique ou un lien critique, ainsi qu'un circuit ou système non cohérent,

— La figure 4 représente schématiquement un autre mode de réalisation du système conforme à l'invention, réalisé sous forme modulaire.

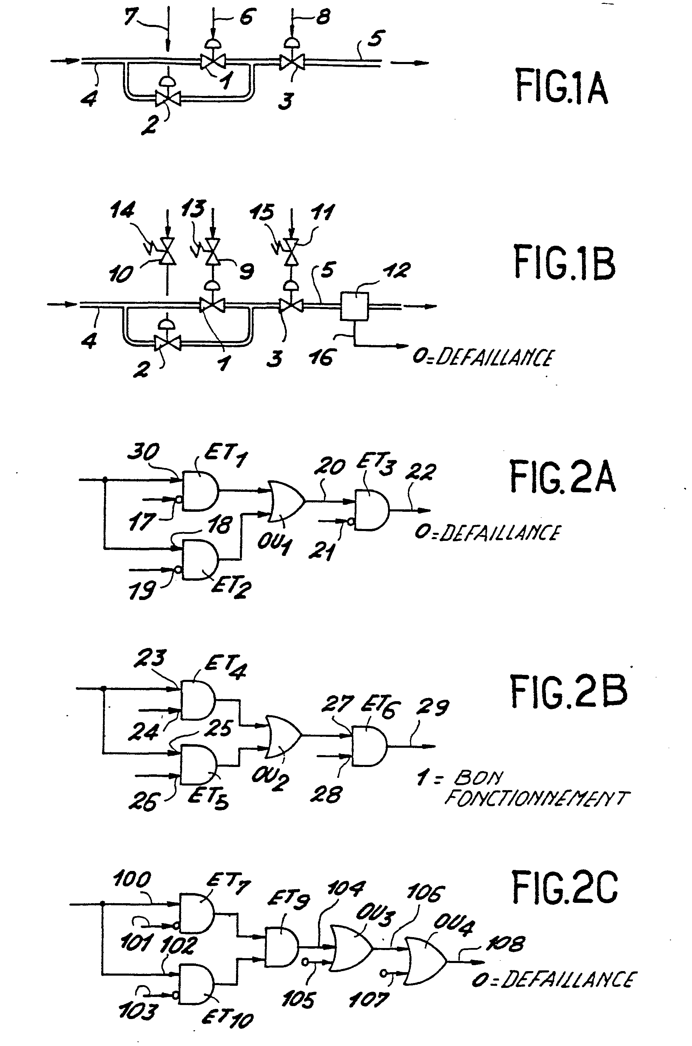

La figure 1A représente schématiquement un circuit hydraulique qui permet d'établir par exemple, la circulation entre un conduit amont 4 et un conduit aval 5, grâce à trois vannes pneumatiques, 1, 2, 3 dont l'ouverture ou la fermeture peut être commandée par la présence ou l'absence d'air comprimé dans les conduits de commande 6, 7, 8. Dans ce circuit, les vannes constituent les seuls composants qui peuvent être, soit en état de défaillance, soit en état de bon fonctionnement. Le circuit hydraulique considéré est défaillant si le fluide n'est pas transmis dans le conduit aval 5. Lorsque seules les vannes 1 et 2 sont défaillantes, le fluide ne passe plus du conduit amont 4 vers le conduit aval 5 ; il en est de même lorsque les vannes 1 et 3 sont défaillantes. Il en résulte que l'ensemble des repères 1 et 2 constitue une coupe et que de la même façon, l'ensemble des repères 1 et 3 constitue aussi une coupe. Dans ce circuit, conformément aux définitions qui ont été données plus haut, la coupe constituée par les repères 1 et 2 (portes $ET_1$, $ET_2$) est une coupe d'ordre 2 ; il en est de même pour la coupe 1, 3. La coupe 1, 2 est minimale car si on remet le composant 1 en bon fonctionnement, le système redevient en bon fonctionnement ; il en est de même pour le composant 2. Ces composants sont, comme on le verra plus loin, des composants critiques. Par contre la coupe 1, 3 n'est pas minimale car si l'on remet en bon fonctionnement le composant 1, le système reste défaillant.

Lorsque seules les vannes 1 et 3 sont en bon fonctionnement, le fluide passe d'amont en aval, si bien que l'ensemble des repères 1 et 3 constitue un lien. Ce lien est d'ailleurs un lien minimal d'ordre 2 puisqu'il est impossible de trouver une autre configuration, en supprimant le bon fonctionnement d'une de ces deux vannes, qui permette de maintenir le circuit en état de bon fonctionnement. Les composants 1, 3 sont, comme on le verra plus loin, des composants critiques.

La figure 1B représente schématiquement le circuit de la figure précédente dans lequel ont été rajoutés, pour chacune des vannes 1, 2, 3, sur les conduits de commande 6, 7, 8, de celles-ci, des moyens 9, 10, 11 qui permettent de simuler l'état de défaillance ou de bon fonctionnement de ces vannes. Un détecteur 12 de passage du fluide peut être disposé sur le conduit aval 5 pour indiquer par exemple, par un état logique 0, sur sa sortie 16, la défaillance du circuit hydraulique, lorsqu'un fluide fourni au conduit amont 4, ne se retrouve pas dans le conduit aval 5. Les moyens 9, 10, 11, qui permettent de simuler la défaillance des vannes qui leur correspondent, présentent respectivement des entrées de commande 13, 14, 15. Ces moyens sont respectivement constitués, par exemple, par une vanne à commande électrique qui intervient sur la commande pneumatique de chacune des vannes 1, 2, 3 du circuit. L'entrée de commande de chacune des vannes à commande électrique agit de manière que si une tension est appliquée sur cette entrée, cette vanne se ferme et coupe l'air comprimé qui arrive dans le conduit de commande de la vanne correspondante du circuit hydraulique. Cet arrêt d'arrivée de l'air comprimé simule la défaillance de la vanne correspondante dans le circuit. Cette défaillance étant simulée, il suffit alors d'observer le signal de sortie du détecteur de passage de fluide 12 pour savoir si cette défaillance interrompt ou non le passage du fluide vers la sortie des circuits hydrauliques.

La figure 2A représente un circuit logique équivalent au circuit hydraulique de la figure 1B ; ce circuit équivalent permet d'étudier les coupes et notamment les coupes critiques du circuit hdyraulique, c'est-à-dire sa réponse aux défaillances simulées. Dans ce circuit équivalent, la vanne 1 ainsi que la vanne 9 à commande électrique, qui permet de simuler la défaillance de la vanne 1, sont remplacées par la porte $ET_1$, une entrée directe 30 de cette porte est portée à un niveau logique 1, pour simuler l'arrivée du fluide dans le conduit amont du circuit hydraulique et une entrée inversée de simulation 17 est portée à un état logique de niveau 1, pour simuler la défaillance de ce circuit. De la même manière, la porte $ET_2$ est équivalente à la vanne 2 associée à la vanne de simulation 10, à commande électrique. Un état logique de niveau 1 sur l'entrée 18 de cette porte simule le passage du fluide, tandis qu'un état logique de niveau 1, sur l'entrée inverse de simulation 19, simule la défaillance de cette porte. Enfin, la porte $ET_3$ est équivalente à la vanne 3 et à la vanne de simulation 11, à commande électrique. L'entrée directe 20 de cette porte, portée à un état logique 1, simule le passage du fluide, tandis que l'entrée inverse de simulation 21, portée à un état logique 1, simule la défaillance de cette porte. La porte $OU_1$ est équivalente à la jonction entre les sorties des vannes 1 et 2. Ce circuit équivalent au circuit hydraulique de la figure 1B, est considéré en état de défaillance lorsque la sortie 22 de la porte $ET_3$ est à un niveau logique 0. On voit que grâce à ce circuit équivalent, il est possible d'étudier les coupes du circuit hydraulique représenté sur la figure 1B, de manière beaucoup plus simple. Les portes $ET_1$ et $ET_2$ par exemple sont équivalentes aux vannes 1 et 2 qui définissent une coupe.

Cette coupe est critique puisqu'elle définit un état de défaillance critique : en effet, si la vanne 1 ou si la vanne 2 est remise en état de bon fonctionnement, le circuit hydraulique est remis en état de bon fonctionnement.

La vanne 1 est donc un composant critique. Il en est de même de la vanne 2 ; cette coupe qui ne comprend que des composants critiques est même minimale.

La coupe constituée par les vannes 1 et 3 définit elle aussi un état de défaillance critique : en effet, le circuit est remis en état de bon fonctionnement si la vanne 3 est remise en état de bon fonctionnement. Cette vanne 3 est donc un composant critique. La vanne 1 par contre n'est pas un composant critique puisque sa remise en état de bon fonctionnement ne change rien à l'état de défaillance du circuit. On peut donc dire que la coupe constituée par les vannes 1 et 3 est une coupe critique puisqu'elle définit un état de défaillance critique, mais cette coupe n'est pas minimale.

La recherche des coupes critiques et composants critiques de ces coupes peut donc être effectuée facilement à l'aide de circuits logiques équivalents, du type de celui de la figure 2A, en appliquant des signaux de niveau logique 1 sur les entrées de simulation des portes correspondant aux composants dont on veut simuler la défaillance, et des signaux de niveau logique 0 sur les entrées de simulation des portes correspond aux composants dont on veut simuler le bon fonctionnement ou la remise en état de bon fonctionnement momentanée.

Le circuit de la figure 2B est un circuit logique équivalent au circuit hydraulique de la figure 1B et il permet d'étudier les liens de ce circuit. De la même manière que précédemment, les vannes 1, 2, 3 ainsi que leurs vannes de commande de simulation 9, 10, 11, à commande électrique sont respectivement remplacées par les portes $ET_4$, $ET_5$ et $ET_6$. La porte $OU_2$ représente la jonction entre les sorties des vannes 1 et 2. Comme précédemment, les portes $ET_4$, $ET_5$ et $ET_6$ présentent des entrées 23, 25, 27 qui, lorsqu'elles sont portées à un niveau logique 1, simulent le passage du fluide dans le circuit hydraulique. Les entrées de simulation 24, 26, 28 de ces portes permettent de simuler le bon fonctionnement de chacune des vannes, lorsqu'elles sont portées à un niveau logique 1. Lorsque le circuit est en état de bon fonctionnement, la sortie 29 de la porte $ET_6$ est à un niveau logique 1. Ainsi, ce circuit logique équivalent au circuit hydraulique de la figure 1B permet d'étudier les liens de ce circuit hydraulique, c'est-à-dire son état de bon fonctionnement, en fonction de l'état de bon fonctionnement de chacun de ses composants.

Dans le circuit de la figure 2B, les portes $ET_4$ et $ET_6$ sont équivalentes aux vannes 1 et 3 qui définissent un lien. Ce lien est critique puisqu'il définit un état de bon fonctionnement critique : en effet, si la vanne 1 ou si la vanne 3 est mise en état de défaillance, le circuit est mis en état de défaillance, puisque la vanne 2 qui ne fait pas partie du lien est déjà en état de défaillance. La vanne 1 ou la vanne 3 est un composant critique du lien critique. Ce lien qui ne comporte que des composants critiques est même un lien minimal.

La recherche des liens critiques et des composants critiques de ces liens peut donc être effectuée facilement à l'aide de circuits logiques équivalents du type de celui de la figure 2B, en appliquant des signaux de niveau logique 1 sur les entrées de simulation des portes correspondant aux composants du circuit ou système dont on veut simuler le bon fonctionnement, et des signaux de niveau logique 0 sur les entrées de simulation des portes correspondant aux composants dont on veut simuler la défaillance ou la remise en état de défaillance momentanée. Bien entendu, pour être conforme avec la logique définie à la figure 2A, la sortie de porte $ET_6$ doit être suivie d'un inverseur (non représenté) pour que le bon fonctionnement corresponde à un niveau logique 0.

La figure 2C va permettre de mieux comprendre ce qu'est un système ou circuit « non cohérent ». Le circuit logique représenté sur cette figure peut être un circuit équivalent à un système ou circuit, hydraulique par exemple, ou de tout autre type.

Ce circuit logique comprend les portes $ET_7$, $ET_{10}$, $ET_9$, $OU_3$, $OU_4$. La porte $ET_7$ comprend une entrée 100 qui est portée en permanence à un niveau logique 1, tandis que son autre entrée inversée de simulation 101 peut être portée à un niveau logique 1 ou à un niveau logique 0 pour simuler la défaillance ou le bon fonctionnement du composant auquel cette porte correspond dans le circuit ou système à étudier.

La porte $ET_{10}$ comprend une entrée 102 qui est portée en permanence à un niveau logique 1, tandis que son autre entrée inversée de simulation 103 est portée à un niveau logique 1 ou à un niveau logique 0 pour simuler la défaillance ou le bon fonctionnement du composant auquel cette porte correspond dans le circuit ou système à étudier.

Les sorties des portes $ET_7$ et $ET_{10}$ sont reliées respectivement aux entrées de la porte $ET_9$.

La porte $OU_3$ comprend une entrée 104 qui est reliée à la sortie de la porte $ET_9$ et une autre entrée 105 qui peut être portée à un niveau logique 1 ou à un niveau logique 0 pour simuler une panne ou défaillance du composant correspondant ou le bon fonctionnement de ce composant. Enfin, la porte $OU_4$ comprend une entrée 106 qui est reliée à la sortie de la porte $OU_3$, et une autre entrée 107 qui peut être portée à un niveau logique 1 ou à un niveau logique 0 pour simuler une défaillance ou le bon fonctionnement du composant correspondant.

Dans cet exemple de circuits de simulation, on peut montrer que si le circuit est en état de défaillance (signal de niveau logique 0 sur la sortie 108 de la porte $OU_4$) par suite de la défaillance simulée de certains composants, la mise en état de défaillance simulée de composants qui étaient en état de bon fonctionnement entraîne la mise en état de bon fonctionnement du système.

Si par exemple, une défaillance est simulée par l'application d'un signal de niveau logique 1 sur l'entrée 101 de la porte $ET_7$, alors que tous les autres composants sont en état de bon fonctionnement (signaux de niveau logique 0 sur leurs entrées 103, 105, 107 de simulation), la sortie 108 de la porte $OU_4$ est au niveau logique 0 indiquant une défaillance. Si l'on simule alors une défaillance par application d'un signal de niveau logique 1 sur l'entrée 105 de la porte $OU_3$ ou sur l'entrée 107 de la porte $OU_4$, pour simuler un état de défaillance des composants correspondants, la sortie 108 de la porte $OU_4$ passe au niveau logique 1 indiquant ainsi une remise en état de bon fonctionnement du système ou circuit simulé, ce qui est non cohérent.

Il en est de même si une défaillance est simulée sur les entrées 101 et 103 des portes $ET_7$, $ET_{10}$ par application d'un signal de niveau logique 1 sur ces entrées inversées, alors que les autres entrées 105 et 107 reçoivent des signaux de niveau logique 0 simulant un bon fonctionnement des composants correspondants : la sortie 108 de la porte $OU_4$ est au niveau logique 0 indiquant la défaillance du système simulé.

Si on simule alors une défaillance des composants correspondant à l'une des portes $OU_3$ ou $OU_4$, par application d'un signal de niveau logique 1 sur l'entrée 105 ou sur l'entrée 107 de l'une ou l'autre de ces portes, le signal sur la sortie 108 passe au niveau logique 1 indiquant ainsi une remise en état de bon fonctionnement du circuit ou système simulé, ce qui est encore non cohérent.

Dans ce dernier exemple, si la porte $ET_7$ simule par exemple un composant numéroté 1 d'un système, et si la porte $ET_{10}$ simule un composant numéroté 2, les portes $OU_3$ et $OU_4$ simulant des composants numérotés 3 et 4, respectivement il est possible de dire que les composants 1, 2 décrivent une coupe et que le composant 4 est non cohérent pour la coupe 1, 2.

Comme on le verra plus loin en détail, le système de test conforme à l'invention permet d'appliquer sur chacune des entrées de simulation de défaillance ou de bon fonctionnement des composants d'un circuit de simulation, des signaux logiques de niveau 1 ou 0. Il permet aussi sur l'une de ses sorties, de vérifier si dans le système simulé, il existe au moins une coupe ou un lien critique. Il permet également de repérer le ou les composants critiques de chaque coupe et chaque lien. Enfin, ce système de test permet d'indiquer si un système ou un circuit est non cohérent et quel est le composant non cohérent dans une coupe de ce circuit.

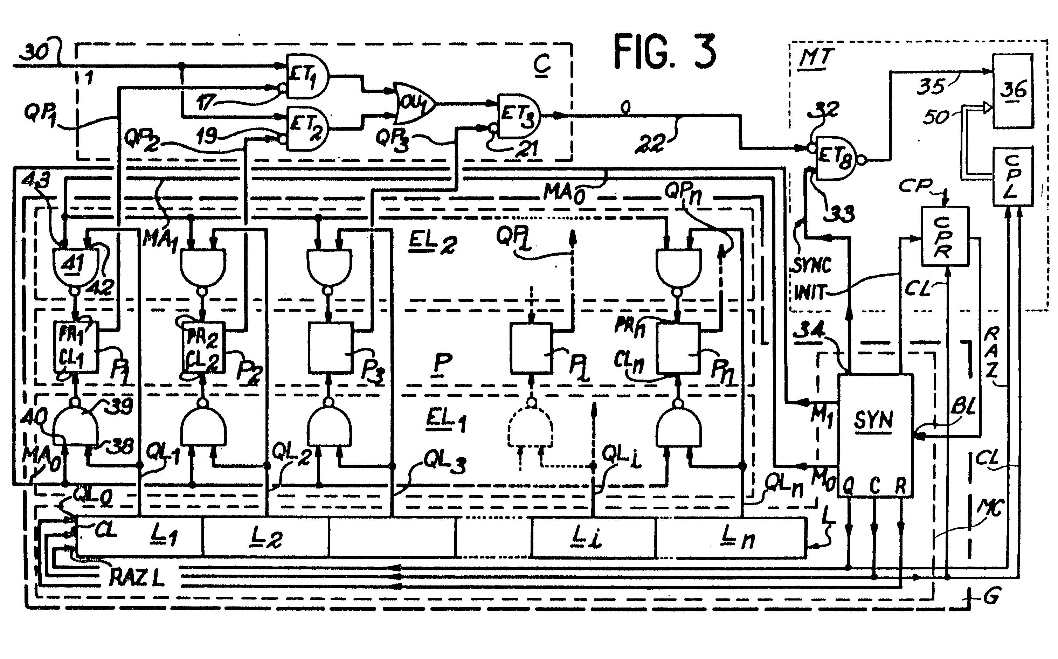

La figure 3 représente de manière schématique un système de test de la défaillance ou du bon fonctionnement d'un circuit C à n composants logiques, repérés de 1 à n, de manière prédéterminée. Le circuit C représenté en exemple sur cette figure est le même que celui de la figure 2A. Ce circuit est équivalent au circuit de la figure 1B et permet d'étudier les coupes de ce circuit. Les composants qu'il permet de simuler sont constitués par les portes $ET_1$, $ET_2$ et $ET_3$. Comme indiqué plus haut, l'entrée 30 de ce circuit est portée à un niveau logique 1 pour simuler le passage du fluide dans le circuit hydraulique correspondant. La sortie de ce circuit est représentée en 22, tandis que les entrées de simulation des différents composants sont référencées 17, 19, 21. La présence d'un niveau logique 0 sur la sortie 22 de ce circuit indique la défaillance de celui-ci.

Il est bien évident que dans l'exemple du circuit C représenté sur cette figure, le système de l'invention permet de tester des coupes et plus particulièrement des coupes critiques sur un circuit constitué de trois composants, mais qu'il pourrait permettre de tester des coupes critiques sur un circuit comportant un nombre n de composants, bien supérieur à 3.

Il est bien évident aussi que d'autres composants supposés non défaillants dans l'étude, peuvent être simulés dans le circuit C ; c'est par exemple le cas de la porte $OU_1$. Avec le circuit C, tel qu'il est décrit, plusieurs coupes peuvent être étudiées : par exemple la coupe simulant une défaillance sur les entrées 17, 19, 21 ou encore la coupe simulant une défaillance sur les entrées 17, 19, ou encore la coupe simulant une défaillance sur l'entrée 21, ou encore la coupe simulant une défaillance sur les entrées 17, 21, etc...

Enfin, le système qui va être décrit dans son application au test des composants d'une coupe et plus particulièrement d'une coupe critique dans un circuit, tel que le circuit de la figure 2A, peut être appliqué de la même manière au test des composants d'un lien et plus particulièrement d'un lien critique dans un circuit tel que le circuit de la figure 2B.

Il peut aussi être appliqué à la détermination des composants non cohérents dans une coupe ou un lien d'un circuit tel que le circuit de la figure 2C.

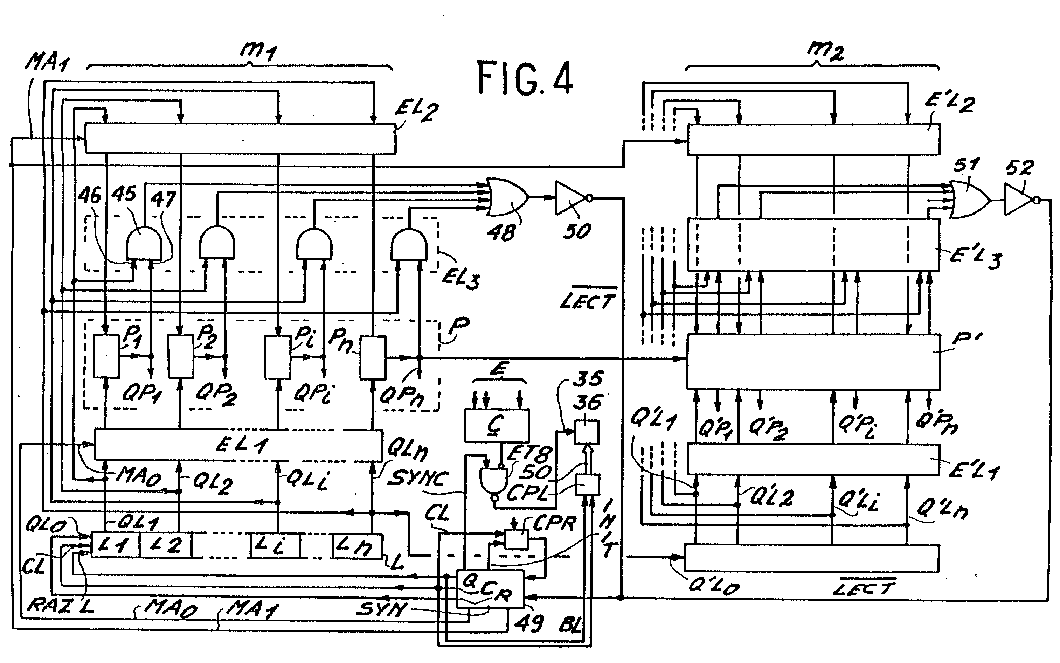

Le système de test représenté sur la figure 4 comprend un générateur G de signaux logiques de niveau 0 Et 1 disponible sur des sorties $QP_1$, $QP_2$, ... $QP_i$, ... $QP_n$.

Le système de test comprend aussi des moyens de test MT connectés à des entrées et des sorties du générateur G, pour tester le niveau logique du signal sur la sortie du circuit C testé, pour différentes configurations des signaux de niveau logique 1 ou 0 appliqués sur les entrées de simulation du circuit C de simulation d'un circuit ou système. Ces différentes configurations permettent, comme on le verra plus loin en détail de déterminer les états de défaillance ou de bon fonctionnement critique d'un circuit, ainsi que sa non-cohérence éventuelle.

Les moyens de test MT comprennent une porte $ET_8$ à sa sortie inversée, dont une entrée 32 inverse le niveau du signal logique provenant de la sortie 22 du circuit C. L'autre entrée 33, de la porte $ET_8$ est reliée à une sortie du générateur G et plus précisément à une sortie 34 de moyens de synchronisation SYN appartenant à ce générateur et qui permettent d'appliquer à cette porte un signal impulsionnel de synchronisation SYNC, de niveau logique 1, à chaque fois qu'un signal de simulation est appliqué à un composant.

Dans l'exemple d'application du système représenté sur la figure 3, à l'étude des coupes du circuit C correspondant au circuit de la figure 2A, des sorties $QP_1$, $QP_2$, $QP_3$ du générateur G sont reliées respectivement aux entrées de simulation 17, 19, 21 des portes $ET_1$, $ET_2$, $ET_3$ du circuit C. Ce générateur, qui sera décrit plus loin en détail, permet d'appliquer à l'ensemble des composants, décrivant une coupe par exemple, des signaux logiques de niveau 1 simulant leur défaillance et des niveaux logique 0 simulant le bon fonctionnement des autres composants, puis successivement à chaque composant décrivant la coupe, un signal logique de niveau 0 simulant l'état de bon fonctionnement de ce composant suivi d'une remise au niveau logique 1, afin d'observer si en sortie du circuit, la remise en état de bon fonctionnement de l'un des composants maintient ou non le circuit en état de défaillance.

Si au cours d'un test l'un des composants est remis en état de bon fonctionnement et que le circuit est lui aussi remis en état de bon fonctionnement, c'est que la coupe étudiée est une coupe critique, le composant considéré étant alors un composant critique, et que ce composant met le circuit en état de défaillance critique.

Si on étudie donc une coupe sur le circuit C, ou un circuit analogue, la défaillance de ce circuit se traduit par un signal de niveau logique 0 sur la sortie 22 du circuit C. Il en résulte qu'une coupe étudiée sur le circuit C est critique, pour un composant de cette coupe, si la sortie inversée de la porte $ET_8$ est remise à un niveau logique 1, lorsque ce composant est remis en état de bon fonctionnement (niveau logique 0 appliqué sur l'entrée de simulation de la porte correspondant au composant). Le composant considéré peut alors être qualifié de critique. C'est le cas par exemple des composants de la coupe correspondant aux portes $ET_1$ et $ET_2$. Chacun des deux composants de cette coupe est critique ; cette coupe est même minimale comme indiqué plus haut.

Si par contre, lors de la simulation de l'un des composants du circuit C qui traduit le bon fonctionnement de ce composant (niveau logique 0 sur l'entrée de simulation de la porte correspondante du circuit C), la sortie 22 du circuit C reste au niveau logique 0 et la sortie de la porte $ET_8$ passe au niveau logique 0 lors de l'application du signal SYNC, c'est que le composant considéré n'est pas critique pour la coupe choisie. En effet, la remise en état de bon fonctionnement de ce composant laisse le circuit en état de défaillance.

Au cours des tests, le générateur G applique à l'ensemble des entrées de simulation des portes correspondant aux composants de la coupe, un niveau logique 1 simulant une défaillance, puis successivement, l'entrée de simulation de chaque composant est portée à un niveau logique 0 simulant l'état de bon fonctionnement de ce composant, puis à un niveau logique 1 simulant à nouveau un état de défaillance ; les entrées de simulation des autres composants correspondant à la coupe sont, pendant la durée de la simulation d'un composant, à un niveau logique 1 simulant la défaillance de ceux-ci.

On peut de la même manière rechercher, par exemple dans le circuit C de la figure 2B, l'existence de liens critiques ainsi que les composants critiques dans ces liens.

Dans cette application, les entrées de simulation 24, 26, 28 du circuit C de la figure 2B sont reliées respectivement aux sorties $QP_1$, $QP_2$, $QP_3$ du générateur G, tandis que la sortie 29 de la porte $ET_6$ est reliée à l'entrée 32 de la porte $ET_8$. Dans cet exemple, le fonctionnement est le suivant : on applique par exemple des signaux de niveau logique 1 traduisant le bon fonctionnement d'un composant sur les entrées de simulation 24, 28 des portes $ET_4$, $ET_6$, dont les composants correspondants constituent un lien, et un signal de niveau logique 0 sur l'entrée 26 de la porte $ET_5$ (traduisant la défaillance du composant correspondant), qui ne fait pas partie du lien. La sortie 29 de la porte $ET_6$ est alors au niveau logique 1, ce qui traduit l'état de bon fonctionnement du circuit ou système simulé. La sortie de la porte $ET_8$ est alors au niveau logique 1 lorsque la porte $ET_8$ reçoit l'impulsion SYNC sur son entrée 33. Si on applique alors un niveau logique 0 sur l'entrée 24 de la porte $ET_4$ pour traduire la défaillance du composant correspondant, la sortie 29 passe au niveau logique 0 (état de défaillance du circuit) ; la sortie de la porte $ET_8$ passe aussi au niveau logique 0 traduisant la défaillance du circuit. Le composant simulé par la porte $ET_4$ est donc un composant critique et le lien considéré est lui aussi critique. Ce lien est même minimal puisqu'on pourrait montrer que l'autre composant du lien, simulé par la porte $ET_6$, est lui aussi critique. Le circuit ou système simulé présente donc des états de défaillance critique.

Au cours des tests, le générateur G applique à l'ensemble des entrées de simulation des portes correspondant aux composants du lien, un signal de niveau logique 1, simulant leur bon fonctionnement, puis successivement, l'entrée de simulation de chaque composant est portée à un niveau logique 0 simulant l'état de défaillance de ce composant, puis à un niveau logique 1 simulant à nouveau un état de bon fonctionnement ; les entrées de simulation des autres composants correspondant au lien sont, pendant la durée de la simulation d'un composant, à un niveau logique 1 simulant le bon fonctionnement de ceux-ci.

On peut également rechercher de la même manière, à l'aide du système de l'invention, si le circuit ou système correspondant au circuit de la figure 2C par exemple, est non cohérent. Dans ce cas, les entrées de simulation 101, 103, 105, 107 du circuit de simulation sont reliées respectivement aux sorties $QP_1$, $QP_2$, $QP_3$, $QP_4$ du générateur G et la sortie 108 de la porte $OU_4$ est reliée à l'entrée 32 de la porte $ET_8$.

Dans cette application, le générateur G applique par exemple sur les entrées 103, 105, 107 de simulation, des signaux de niveau logique 0 simulant le bon fonctionnement des composants correspondants, et un signal de niveau logique 1 sur l'entrée 101 simulant la défaillance du composant correspondant. La sortie 108 de la porte $OU_4$ est au niveau logique 0 indiquant la défaillance du circuit ou système simulé. La sortie de la porte $ET_8$ des moyens de test est alors elle aussi au niveau 0 lorsque l'entrée 33 de cette porte reçoit l'impulsion SYNC.

Si le générateur applique alors un signal de niveau logique 1 sur l'entrée 105 de la porte $OU_3$ ou sur l'entrée 107 de la porte $OU_4$ exprimant la défaillance des composants correspondants, la sortie 108 de la porte $OU_4$ et la sortie de la porte $ET_8$ des moyens de test passent au niveau logique 1 exprimant la remise en état de bon fonctionnement du circuit ou système simulé. Ce circuit ou système est bien non cohérent puisqu'étant défaillant, la mise en état de défaillance d'un composant qui était en état de bon fonctionnement provoque la remise du circuit en état de bon fonctionnement. Le composant du circuit simulé correspondant à la porte $OU_4$ est un composant non cohérent. On verra plus loin en détail comment les moyens de test permettent de déterminer les coupes critiques, les liens critiques, les composants critiques et la non-cohérence, à partir des signaux fournis par la porte $ET_8$.

Le générateur G comprend un ensemble P dont au moins n bascules $P_1$, $P_2$, $P_3$, $P_i$, ..., $P_n$ permettent de mémoriser les états logiques de simulation des composants du circuit ou système à étudier. Les sorties $QP_1$, $QP_2$, ...$QP_i$, ...$QP_n$ de ces bascules sont, comme on l'a mentionné plus haut, respectivement reliées aux entrées de simulation des composants du circuit C équivalent logique du circuit ou système à étudier. C'est ainsi que dans l'exemple considéré, les sorties $QP_1$, $QP_2$, $QP_3$ sont respectivement reliées aux entrées de simulation 17, 19, 21 des composants du circuit C de la figure 2A. Dans ce cas et comme indiqué plus haut, c'est une coupe d'ordre 3 qui est étudiée.

Comme on le verra plus loin en détail, les états logiques de simulation de défaillance ou de bon fonctionnement des composants du circuit C sont chargés dans ces bascules, à l'initialisation du système. Le générateur comprend aussi des moyens de commande MC dont les sorties $QL_1$, $QL_2$, $QL_3$, ..., $QL_i$, ..., $QL_n$ sont reliées à des entrées d'un ensemble logique $EL_1$, $EL_2$ de sélection et de commande des bascules $P_i$, pour que les sorties de ces bascules de mémorisation $P_i$, sélectionnées pour simuler les composants déterminés du circuit, présentent l'état logique 1 pour simuler une défaillance, puis pour que chaque sortie présente successivement l'état logique inverse (zéro), simulant le bon fonctionnement du composant correspondant ou réciproquement.

Comme on le verra plus loin en détail, ces changements d'état logique sur les sorties des bascules $P_i$ sélectionnées, sont commandés par des signaux $MA_0$, $MA_1$, provenant des moyens de synchronisation SYN ; ces signaux sont appliqués respectivement aux ensembles logiques $EL_1$ et $EL_2$. Les moyens de commande MC comprennent un registre à décalage L ainsi que les moyens de synchronisation SYN mentionnés plus haut. Le registre à décalage L comporte au moins n bascules de commande $L_1$, $L_2$, ..., $L_i$, ..., $L_n$ qui sont reliées en série. Les sorties $QL_1$, ..., $QL_i$, ..., $QL_n$, de ces bascules constituent des sorties de commande de l'ensemble P de mémorisation d'états logiques de simulation. La première bascule $L_1$ du registre à décalage L présente trois entrées reliées respectivement aux sorties R, Q, C, des moyens de synchronsiation SYN ; cette bascule reçoit aussi un signal RAZL de remise à zéro du contenu du registre à décalage, un signal $QL_0$ présentant un état logique prédéterminé qui est mémorisé, avant décalage, dans la bascule $L_1$ du registre, et un signal CL d'horloge qui permet de commander les décalages dans le registre L du signal $QL_0$ mémorisé initialement dans la bascule $L_1$. Les entrées de commande de l'ensemble logique $EL_1$, $EL_2$ de sélection sont respectivement reliées aux sorties de commande $QL_1$, ..., $QL_i$, ..., $QL_n$ des bascules $L_1$, ..., $L_i$, ..., $L_n$. Les sorties de cet ensemble logique sont reliées à des entrées de commande $PR_1$, ..., $PR_i$, ..., $PR_n$, $CL_1$, ..., $CL_i$, ..., $CL_n$, des bascules de l'ensemble P. L'ensemble logique $EL_1$, $EL_2$ est constitué de manière que chaque bascule $P_i$ sélectionnée dans l'ensemble de mémorisation P, pour appliquer un signal de simulation sur l'entrée de simulation d'un composant prédéterminé du circuit C corresponde à la présence d'un niveau logique prédéterminé (niveau 1) sur la sortie de commande $QL_i$ de la bascule $L_i$ correspondante. Cet ensemble logique présente en outre deux entrées supplémentaires de commande, aptes à recevoir respectivement les signaux $MA_0$, $MA_1$, de commande de test, pour que la sortie de chaque bascule $P_i$ sélectionnée présente successivement l'état logique de la bascule à l'initialisation (état logique 1), l'état logique inverse (état logique 0) de l'état initial, puis à nouveau l'état logique initial 1 de cette bascule. (dans le cas de l'étude d'une coupe).

Les moyens logiques de synchronisation SYN produisent sur leurs sorties des signaux SYNC de commande de mémorisation des résultats de simulation, les signaux RAZL de remise à zéro du registre à décalage L, ainsi que les signaux $QL_0$ et CL de mémorisation et de commande de décalage, appliqués à la première bascule du registre L. Ces moyens de synchronisation produisent également sur une sortie, un signal INIT qui permet d'initialiser un compteur CPR des moyens de test MT, qui sera décrit ci-après.

Le compteur CPR des moyens de test MT est chargé par une entrée CP, à l'initialisation, par une valeur correspondant à l'ordre de la coupe ou du lien (valeur égale à 3, si l'on considère par exemple la coupe constituée par exemple sur la figure 2A, par les portes $ET_1$, $ET_2$, $ET_3$). Ce compteur présente une entrée qui est reliée à une sortie des moyens de synchronisation SYN pour recevoir un signal d'initialisation INIT, à l'initialisation du système. Le contenu de ce compteur décroît d'une unité pour chaque signal CL reçu sur une autre entrée reliée à une sortie C des moyens de synchronisation SYN. Une sortie de ce compteur est reliée, comme on le verra plus loin en détail, à une entrée BL de commande d'arrêt des moyens de synchronisation SYN, pour arrêter le système lorsque tous les composants de la coupe ou du lien ont été simulés.

Enfin, la sortie 35 de la porte $ET_8$ des moyens de test MT est reliée à une entrée de moyens 36 qui permettent d'indiquer qu'un composant d'une coupe ou d'un lien est critique. Ces moyens 36 peuvent être constitués par exemple, par un indicateur lumineux. Ils comportent aussi des entrées 50 reliées à des sorties d'un autre compteur CPL qui intervient, comme on le verra plus loin en détail, notamment pour commander le balayage des entrées de simulation du circuit testé, par les signaux de niveaux logiques 0 ou 1. Ce compteur CPL qui fait aussi partie des moyens de test MT comporte des entrées qui sont respectivement reliées aux sorties Q et C des moyens de synchronisation SYN, pour recevoir respectivement le signal RAZL de remise à zéro au début du test d'un circuit, et les signaux d'horloge CL.

L'ensemble logique de sélection et de commande comprend deux ensembles $EL_1$, $EL_2$ de porte ET présentant chacune une·sortie inversée. Ces deux ensembles comprennent chacun respectivement un nombre de portes égal au nombre n de bascules $P_i$ de l'ensemble P, ainsi qu'au nombre n de bascules $L_i$ du registre à décalage L. Chaque porte ET à sortie inversée du premier ensemble logique $EL_1$ présente une entrée qui est reliée à une sortie de commande de la bascule $L_i$ correspondante et une autre entrée qui est reliée à la sortie $M_0$ des moyens de synchronisation pour recevoir le signal de commande de test $MA_0$.

C'est ainsi, par exemple sur la figure, que l'entrée 38 de la première porte 39 de l'ensemble $EL_1$ est reliée à la sortie $QL_1$ du registre L, tandis que l'autre entrée 40 de cette porte reçoit le signal $MA_0$ de commande de test, provenant des moyens de synchronisation SYN. Les sorties des portes de ce premier ensemble logique sont respectivement reliées, après inversion, à l'une des entrées de commande $CL_1$, ... $CL_i$, ... $CL_n$ des bascules $P_i$ de l'ensemble P. Les bascules de l'ensemble P sont chargées à l'initialisation du système. Le signal $MA_0$ de niveau logique 1 qui, après passage dans chaque porte de l'ensemble $EL_1$ devient un signal de niveau logique 0 est appliqué successivement sur les entrées de commande $CL_1$, $CL_2$, $CL_3$ des bascules de l'ensemble P et fait passer ces bascules à l'état logique 0, si leur état initial était au niveau 1.

De même manière, chaque porte ET à sortie inversée du deuxième ensemble logique $EL_2$

présente une entrée qui est reliée à une sortie de commande de la bascule $L_i$ correspondante du registre à décalage L, et une autre entrée qui est reliée à la sortie $M_1$ des moyens de synchronisation SYN, pour recevoir les signaux $MA_1$ de commande de test. Les sorties inversées de ces portes ET du deuxième ensemble logique sont respectivement reliées aux autres entrées de commande $PR_1$, ..., $PR_i$, ..., $PR_n$ des bascules de l'ensemble P pour ramener ces bascules dans leur état initial (niveau logique 1) au cours des tests, grâce aux signaux $MA_1$.

C'est ainsi par exemple que la première porte ET 41 de ce deuxième ensemble logique présente une entrée 42 qui est reliée à la première sortie $QL_1$ de commande du registre à décalage L, et une autre entrée 43, qui reçoit un signal $MA_1$ de niveau logique 1 quand la bascule doit être ramenée dans son état logique initial, c'est-à-dire l'état logique 1.

Les bascules de mémorisation $P_i$ de l'ensemble de mémorisation P d'état logique de simulation peuvent être par exemple les bascules de l'ensemble P du générateur de signaux logiques combinés décrits dans la demande de brevet n° 8 101 392 déposée le 26 janvier 1981 au nom du même demandeur.

Dans ce cas, les bascules ont été initialement chargées grâce à ce générateur de combinaison de manière qu'un agencement prédéterminé de certaines d'entre elles, correspondant à la coupe ou au lien étudié, présente sur ses sorties des signaux logiques de niveau 1.

Dans le système de test qui vient d'être décrit, des bascules successives de l'ensemble P correspondent à chacun des composants qui décrit la coupe ou le lien. Il est bien évident que d'autres bascules $P_k$ peuvent être insérées entre les bascules $P_i$ pour agir sur d'autres composants, non représentés, dont les repères ne correspondent pas à ceux de la coupe ou du lien étudié.

Il est ainsi possible d'obtenir un ensemble P de bascules, ordonnées de 1 à n, dans lequel n représente le nombre total des composants d'un circuit.

Lors des simulations des différents composants du circuit C dont on veut étudier une coupe par exemple, la sortie 22 de ce circuit est au niveau logique 0, si celui-ci est en défaillance.

Au cours des simulations des divers composants d'une coupe de circuit C, s'il apparaît que la mise en état de bon fonctionnement de l'un des composants, par l'application d'un signal de niveau logique 0 sur l'entrée de défaillance de ce composant, remet le circuit C en état de bon fonctionnement, la sortie de ce circuit passe au niveau logique 1. Au moment de l'application de l'impulsion SYNC, sur la porte $ET_8$, il apparaît à la sortie de cette porte, un signal de niveau logique 1. ce signal indique alors que la coupe étudiée est uyne coupe critique.

Le système fonctionne de manière différente dans l'étude d'une coupe selon que les repères de composants en panne et donc les positions des niveaux logiques 1 sur les sorties de l'ensemble de mémorisation P, sont connus ou selon que ces repères ainsi que les positions de niveaux logiques 1 sur les sorties de l'ensemble de mémorisation P, sont inconnus. A l'initialisation du système et dans les deux cas, les sorties du registre P de mémorisation des états logiques de simulation, qui sont reliées aux entrées de simulation des composants du circuit C de la figure 2A par exemple, sont à un niveau logique 1 pour tous les composants correspondant à la coupe et à un niveau logique 0 pour tous les autres composants. Un état logique 0 est présent sur la sortie 22 du circuit C. La coupe représentée par $ET_1$ et $ET_3$ par exemple est critique ; les simulations successives d'états de bon fonctionnement, sur chacune des entrées de simulation des composants de la coupe doivent provoquer au moins une fois l'apparition d'un signal de niveau logique 1 sur la sortie 22 du circuit. Comme indiqué plus haut, dans cette coupe, le composant correspondant à la porte $ET_3$ est un composant critique.

En effet, la remise en état de bon fonctionnement de ce composant (niveau logique 0 sur l'entrée 21 de $ET_3$) remet le circuit en état de bon fonctionnement.

Il en résulte que le système de test de l'invention va opérer de la manière suivante, dans le cas du circuit C représenté en exemple sur la figure et dans le cas où on étudie la coupe $ET_1$, $ET_2$, $ET_3$, d'ordre 3 : les entrées de simulation 17, 19, 21 des portes $ET_1$, $ET_2$, $ET_3$ étant initialement à un niveau logique 1 simulant la défaillance de ces composants, l'entrée 17 de la porte $ET_1$ va être portée à un niveau logique 0, simulant l'état de bon fonctionnement de cette porte, les autres entrées de simulation des deux autres portes restant à un niveau logique 1. La simulation de l'état de bon fonctionnement de la porte $ET_1$ ne change rien sur la sortie 22 du circuit C, ni sur la sortie 35 de la porte $ET_8$ qui reste à l'état logique 0 au moment de l'impulsion SYNC. Le composant correspondant à la porte $ET_1$ n'est donc pas critique. En effectuant le même type de simulation pour la porte $ET_2$, on s'aperçoit que le composant correspondant à cette porte n'est pas critique. Le seul composant critique dans la coupe considérée est celui qui correspond à la porte $ET_3$.

Les mêmes opérations pourraient être bien entendu effectuées sur un circuit représentant un lien, analogue par exemple au circuit de la figure 2B. Si les composants correspondant aux portes $ET_4$ et $ET_6$ constituent un lien d'ordre 2 et que le composant correspondant à la porte $ET_5$ est en défaillance (niveau logique 0 sur son entrée de simulation, on s'aperçoit que le circuit simulé est mis en état de défaillance si l'un des composants correspondant à la porte $ET_4$ ou à la porte $ET_6$ est mis en défaillance (niveau logique 0 sur l'entrée de simulation de l'une de ces portes). Dans ces conditions, on peut dire que ces composants sont critiques pour le lien considéré : lorsque chacun de ces composants est mis en état de défaillance, la sortie de la porte $ET_{10}$ passe au niveau logique 0 au moment de l'impulsion SYNC, indiquant un état de défaillance.

Le lien est critique ; il est même minimal. L'étude de la non-cohérence d'un circuit se ferait de façon semblable, à l'aide par exemple du circuit de la figure 2C. Cette étude a été décrite plus haut.

Dans le mode de réalisation du système de l'invention, représenté sur la figure 3, on a supposé que les repères et donc les positions des bascules de l'ensemble P qui sont à un niveau 1, sont connus.

Dans ce cas, à l'initialisation, le registre L est remis à zéro par un signal de remise à zéro appliqué sur l'entrée RAZL du registre L, commandant ainsi la remise à zéro de toutes les bascules $L_i$. Un signal de mémorisation de niveau logique 1 est alors appliqué sur l'entrée de mémorisation $QL_0$ du registre à décalage L, en même temps qu'une impulsion CL provoquant une mise à l'état logique 1 de la première bascule $L_1$, toutes les autres bascules du registre à décalage L étant au niveau logique 0. Cette opération est celle qui permet d'insérer un niveau logique 1 unique dans le registre L (dans la bascule $L_1$). Cette opération permet, par l'intermédiaire de la première bascule de l'ensemble logique $EL_1$ et de la première bascule de l'ensemble logique $EL_2$, de simuler le premier composant du circuit C en appliquant le signal $MA_0$ sur l'entrée 40 de la porte 39 qui fait passer la sortie $QP_1$ de la bascule $P_1$ de l'ensemble P au niveau logique 0, simulant ainsi le bon fonctionnement du premier composant $ET_1$, dans le cas d'une coupe. Si cette simulation de bon fonctionnement laisse apparaître sur la sortie 22 du circuit C un niveau logique 1 représentant le bon fonctionnement de ce circuit, c'est que la coupe est critique et que le composant simulé est lui-même un composant critique.

Une autre impulsion de décalage est alors appliquée à l'entrée CL du registre à décalage L, tandis que l'entrée $QL_0$ est portée au niveau logique 0. Cette nouvelle impulsion appliquée à l'entrée CL du registre à décalage propage le niveau 1 qui était contenu dans la bascule $L_1$, dans la bascule $L_2$ pour permettre la simulation du composant correspondant à la porte $ET_2$, par l'intermédiaire de la bascule $P_2$.

Il est bien évident que ce niveau est propagé jusqu'à la bascule $L_i$ du registre à décalage L, pour permettre la simulation du composant de rang i, par l'intermédiaire de la bascule $P_i$.

Il est bien évident aussi que si les composants de rang i décrivant une coupe ou un lien ne correspondent pas à des bascules $P_i$ successives, il faut propager le niveau 1 dans le registre L en face de chacune des bascules P correspondant aux composants décrivant la coupe.

Bien entendu aussi, après la simulation de bon fonctionnement du composant $ET_1$, la bascule $P_1$ de l'ensemble P est remise à l'état initial de niveau 1 grâce à l'application du signal $MA_1$ sur la première porte de l'ensemble logique $EL_2$, la bascule $P_1$ ayant été mise à 0 par application du signal $MA_0$ sur la première porte de l'ensemble logique $EL_1$. L'application des signaux $MA_0$ et $MA_1$ est répétée un nombre de fois égal à celui des composants qui constituent la coupe ou le lien.

Le fonctionnement des moyens de test MT va maintenant être expliqué de manière plus détaillée, pour l'étude des composants critiques d'une coupe ou d'un lien, ainsi que pour l'étude d'un système ou d'un circuit non cohérent :

Dans le cas de la recherche du ou des composants critiques d'une coupe, les moyens de test MT fonctionnent de la manière suivante : un niveau logique 1 est introduit, comme indiqué plus haut dans le registre L. Ce niveau logique 1 est ensuite décalé de manière à ce que la bascule L dont la sortie est au niveau logique, soit en face de l'une des bascules du registre P qui est reliée à l'entrée de simulation de la porte correspondant au premier composant décrivant la coupe par exemple. Ce niveau logique 1 permet de simuler une panne du composant correspondant. Ce niveau logique 1 est ensuite supprimé pour être remplacé par un niveau logique 0 simulant le bon fonctionnement du composant correspondant. Les moyens de synchronisation SYN fournissent ensuite une impulsion SYNC. Si la sortie 35 de la porte $ET_8$ est au niveau logique 1, c'est que le composant correspondant est un composant critique. Le numéro de ce composant critique peut être connu grâce au compteur CPL qui a été remis à zéro lorsque le registre L a été lui-même remis à zéro par le signal RAZL, fourni sur la sortie Q des moyens de synchronsiation SYN. Le compteur CPL est incrémenté d'une unité à chaque fois que l'on décale le niveau logique 1 dans le registre L en lui appliquant une impulsion CL provenant de la sortie C des moyens de synchronisation SYN. Les moyens d'indication 36 indiquent alors qu'il s'agit d'un composant critique et les informations fournies sur les entrées 50 de ces moyens 36, par le compteur CPL, indiquent le numéro du composant critique. Lorsqu'un composant vient d'être ainsi testé (qu'il soit critique ou non), ce composant est ensuite remis en état de défaillance (niveau logique 1 sur son entrée de simulation).

On décale ensuite le niveau logique 1 dans le registre L de manière à ce qu'il soit en face de l'une des sorties de l'une des bascules du registre P qui est reliée à une entrée de simulation du composant suivant de la coupe. Les moyens d'indication 36, le compteur CPR et le compteur CPL agissent alors de la manière indiquée plus haut si cet autre composant est lui-même critique. On continue ainsi jusqu'à la fin du balayage de toutes les entrées de simulation du circuit C par des niveaux logiques 1, c'est-à-dire jusqu'à ce que la valeur chargée dans le compteur CPR à l'initialisation (ordre de la coupe) soit atteint. Le compteur CPR arrête alors le balayage par un signal de sortie appliqué sur l'entrée BL des moyens de synchronisation SYN.

Un bon fonctionnement semblable pourrait être décrit pour l'étude du ou des composants critiques d'un lien.

Dans le cas où le système de l'invention est utilisé pour déterminer les composants non cohérents d'un circuit, et plus particulièrement d'une coupe déterminée de ce circuit, son fonctionnement est le suivant : le fonctionnement est très analogue à celui qui intervient lorsque le système sert à déterminer des composants critiques, excepté que, dans le cas de la détermination des composants non cohérents, le registre L fournit sur l'une de ses sorties un signal de niveau logique 1, qui par décalage s'arrête en regard d'une bascule du registre P dont le signal de sortie est au niveau logique 0 (dans l'étude des composants critiques, ce signal de niveau logique 1 s'arrêtait, par décalage, en face d'une bascule du registre P dont le signal de sortie était au niveau logique 1). Le signal de niveau logique 0 fourni sur l'entrée de simulation d'une porte correspondant à un composant du circuit dont on étudie la coupe, met alors en panne le composant correspondant puisque l'entrée de simulation passe au niveau logique 1. Une impulsion de synchronisation SYNC fournie par les moyens de synchronisation SYN est alors appliquée à la porte $ET_8$. Si le signal sur la sortie 35 de cette porte passe alors au niveau logique 1, c'est que le composant considéré est non cohérent pour la coupe. Le numéro du composant peut être connu grâce au compteur CPL. On remet ensuite ce composant en état de bon fonctionnement et on procède au décalage du niveau 1 sur les sorties du registre L, jusqu'à la prochaine bascule du registre P dont la sortie est au niveau logique 0. On recommence ainsi jusqu'au balayage complet de toutes les sorties du registre P qui sont au niveau logique 0.

Pour savoir si tous les composants du circuit testé ont été balayés, on utilise le compteur CPR qui a été chargé par le nombre total de composants. Ce compteur est décrémenté de une unité à chaque fois qu'il reçoit une impulsion CL provenant de la sortie C des moyens de synchronsiation SYN. Ces impulsions CL sont celles qui permettent aussi d'effectuer les décalages dans le registre L.

La figure 4 représente schématiquement deux autres modes de réalisation d'un système conforme à l'invention. L'un de ces modes de réalisation concerne le cas où la position des bascules de l'ensemble de mémorisation P, qui sont à un niveau logique 1, est inconnue. Un autre mode de réalisation, qui est représenté sur la même figure, concerne le cas où la position des bascules de l'ensemble P, qui sont au niveau 1, étant inconnue, le système est construit sous forme modulaire. Les mêmes éléments portent les mêmes références sur cette figure et sur la figure précédente.

Dans le mode de réalisation qui est représenté sur la partie gauche de la figure, le système de l'invention comprend comme précédemment, les bascules $P_1$, $P_2$, ... $P_n$ de l'ensemble de mémorisation P qui délivrent sur leurs sorties les signaux $QP_1$, $QP_2$, ..., $QP_i$, ..., $QP_n$. Il comprend également l'ensemble logique $EL_1$ et $EL_2$ qui reçoit les signaux $MA_0$ et $MA_1$ qui permettent de commmander les changements d'états logiques des sorties prédéterminées des bascules de l'ensemble P ; il comprend également le registre à décalage L, formé des bascules $L_1$, $L_2$, ... $L_i$, ... $L_n$ qui reçoit respectivement sur ses entrées un signal de mémorisation $QL_0$, des signaux de commande de décalage CL, et un signal de remise à zéro RAZL.

On a aussi représenté sur cette figure, les moyens de synchronisation SYN qui commandent le registre à décalage L, qui fournissent les signaux $MA_0$ et $MA_1$ ainsi que les signaux SYNC et INIT. Le circuit de simulation C reçoit sur ses entrées E les signaux de sorties prédéterminées provenant des bascules de l'ensemble P. Le compteur CPR fournit, comme on l'a mentionné plus haut, le signal de blocage BL des moyens de synchronisation SYN.

Enfin, les moyens indiquant que la coupe ou le lien est critique ou que le circuit ou système est non cohérent, sont représentés en 36.

Dans ce mode de réalisation, le système fonctionne de la même manière que précédemment, sauf en ce qui concerne la sélection des bascules de l'ensemble P de mémorisation ; cette sélection permet de simuler le circuit C, sur ses entrées E. En effet, si les bascules $P_i$ correspondant aux composants décrivant une coupe par exemple sont à un niveau 1 permettant de simuler les entrées du circuit C, et sont mélangées à des bascules $P_k$ à un niveau 0, et si la position des bascules $P_i$ de l'ensemble P est inconnue, il est nécessaire de gérer ce registre à décalage L d'une manière différente de celle qui a été décrite plus haut.

Dans ce cas, l'ensemble logique de commande comprend en outre un troisième ensemble logique $EL_3$ de porte ET ; chacune de ces portes présente une entrée qui est reliée à la sortie de commande de la bascule $L_i$ correspondante dans le registre à décalage L, et une autre entrée qui est reliée à la sortie de la bascule $P_i$ correspondante, dans l'ensemble de mémorisation P. C'est ainsi par exemple qu'à la porte ET 45, de l'ensemble logique $EL_3$ présente une entrée 46 qui est reliée à la sortie $QL_1$ de la bascule $L_1$ du registre à décalage L, et une entrée 47 qui est reliée à la sortie $QP_1$ de la bascule $P_1$ de l'ensemble P. Les sorties des portes de l'ensemble logique $EL_3$ sont reliées aux entrées d'une porte OU 48, dont la sortie est reliée à une entrée 49 des moyens de synchronisation SYN, par l'intermédiaire d'un inverseur 50. La sortie de cet inverseur applique à l'entrée 49 des moyens de synchronisation SYN, dans des conditions que l'on définira par la suite, un signal $\overline{LECT}$.

Dans ce mode de réalisation, le système fonctionne de la manière suivante : on propage toujours un niveau logique 1 unique dans le registre L. Pour rechercher par exemple, si l'état logique de la bascule $P_m$ de rang m compris entre 1 et n, est 1, on propage dans le registre L un niveau logique 1 jusqu'à la bascule $L_m$. La porte Et correspondante de l'ensemble logique $EL_3$, dont les entrées sont reliées respectivement à la sortie $QP_m$ de la bascule $P_m$ et à la sortie $QL_m$ de la

bascule $L_m$ du registre à décalage L, valide la transmission du niveau logique 1 de sortie de la bascule $P_m$, vers le circuit SYN, grâce à un signal $\overline{LECT}$ apparaissant alors sur la sortie de l'inverseur 50 qui est reliée à l'entrée 49 des moyens de synchronisation SYN. Ces moyens de synchronisation déclenchent sur la réception du signal $\overline{LECT}$ la validation du signal $MA_0$ puis celle du signal $MA_1$, ces signaux sont appliqués successivement sur les portes ET à sortie inversée, qui correspondent à la bascule $P_m$, dans l'ensemble logique $EL_1$ et $EL_2$.

Initialement, les bascules $P_i$ dont les sorties correspondent à la coupe ou au lien à étudier (pour en rechercher les composants éventuellement critiques ou non cohérents) sont portées au niveau logique 1, par exemple à l'aide du générateur de signaux logiques combinés, décrit dans la demande de brevet précitée. Le compteur CPR est chargé avec l'ordre de la coupe, c'est-à-dire 3, dans l'exemple de coupe d'ordre 3 décrit plus haut, simulée par un circuit comprenant les portes $ET_1$, $ET_2$, $ET_3$. Un niveau logique 1 est alors injecté sur l'entrée $QL_0$ de la bascule $L_1$ après que le registre à décalage L ait été remis à zéro par un signal de remise à zéro apliqué sur son entrée RAZL. Si le signal $\overline{LECT}$ est au niveau logique 0, c'est que la bascule $P_1$ correspondant à la bascule $L_1$ du registre à décalage présente sur sa sortie $QP_1$ un niveau logique 1.

Dans le cas contraire, des impulsions CL sont appliquées sur l'entrée de commande de décalage, du registre à décalage L ; chacune de ces impulsions est suivie d'un test du signal $\overline{LECT}$. Si à la suite d'un test, ce signal est au niveau 1, une nouvelle impulsion est envoyée sur l'entrée CL du registre à décalage, jusqu'à ce que le signal $\overline{LECT}$ soit au niveau logique 0, indiquant ainsi la présence d'un niveau logique 1 sur une sortie d'une bascule de l'ensemble de mémorisation P qui correspond à la bascule qui est au niveau 1 dans le registre L. A chaque fois qu'un niveau logique 1 est trouvé sur une sortie $QP_i$ de l'ensemble de mémorisation P, les signaux $MA_0$ et $MA_1$ sont appliqués successivement sur les entrées des ensembles logiques $EL_1$ et $EL_2$. Toutes ces opérations sont répétées jusqu'à ce que le compteur CPR qui a été chargé initialement à la valeur de l'ordre de la coupe soit à zéro.

En effet, lorsque ce compteur est à zéro, c'est que tous les composants de la coupe ou du lien ont été simulés. Les mêmes opérations seraient effectuées dans le cas d'un lien tel que celui qui est représenté en exemple sur la figure 2B. Le compteur CPL intervient comme précédemment pour repérer un composant critique.

Sur la figure 4, on a aussi représenté un autre mode de réalisation du système de l'invention ; dans ce mode de réalisation, le système fonctionne de la même manière. Le système est ici réalisé sous forme modulaire et on n'a représenté sur cette figure que deux modules $m_1$ et $m_2$, mais il est évident qu'il serait possible d'associer un nombre plus important de modules. Les bascules de mémorisation $P_i$ sont groupées en ensembles identiques P, P', ... reliés en série, de sorte que la dernière bascule $P_n$ du premier module $m_1$ soit reliée à l'entrée de la première bascule de l'ensemble P' du deuxième module $m_2$. Les modules comprennent des registres à décalage L, L', ... identiques. Le registre à décalage du premier module $m_1$ comprend notamment les entrées de mémorisation, de remise à zéro, et de commande de décalage $QL_0$, RAZL et CL, tandis que la sortie de commande $QL_n$ de la dernière bascule du registre à décalage L du premier module $m_1$ est reliée à l'entrée de mémorisation $Q'L_0$ du registre à décalage L' du module suivant. Les modules $m_1$ et $m_2$ comprennent respectivement les premier, deuxième et troisième ensembles logiques $EL_1$, des bascules de l'ensemble de mémorisation P' du second module $m_2$ sont représentées en $Q'P_1$, $Q'P_2$, ..., $Q'P_i$, ..., $Q'P_n$. Les sorties de commande du registre à décalage L' de ce second module sont représentées en $Q'L_1$, ..., $Q'L_i$, ..., $Q'L_n$ ; elles sont reliées aux entrées des ensembles logiques $E'L_1$, $E'L_2$, $E'L_3$. Les sorties du troisième ensemble logique $E'L_3$ du deuxième module $m_2$ sont reliées aux entrées d'une porte OU 51, dont la sortie est reliée à l'entrée de commande 49 des moyens de synchronisation SYN par l'intermédiaire de l'amplificateur-inverseur 52, comparable à l'amplificateur-inverseur 50 et par l'intermédiaire de la ligne BUS.

Comme précédemment aussi, la sortie de l'amplificateur 52 fournit un signal $\overline{LECT}$ à chaque fois qu'un niveau 1 est trouvé sur une sortie $Q'P_i$ d'une bascule $P'_i$ de l'ensemble P', grâce à la présence d'un niveau 1 sur la sortie correspondante $Q'L_i$ d'une bascule $L'_i$ du registre à décalage L'.

En fait, cette construction modulaire permet de disposer d'un nombre important de signaux de simulation, lorsqu'un circuit ou système comportant un très grand nombre de composants est à étudier. Chacun des amplificateurs 50 et 52 est constitué par un transistor monté en collecteur ouvert (connu dans l'état de la technique et décrit dans la demande de brevet précitée).

**Revendications**

1. Système de test de la défaillance ou de bon fonctionnement d'un circuit (C) à composants logiques, dans lequel n composants forment un ensemble de composants repérés de 1 à n de manière prédéterminée et reliés entre eux pour que cet ensemble présente sur une sortie, un état logique qui correspond à l'état de défaillance ou au bon fonctionnement de l'ensemble, et qui dépend de l'état de défaillance ou de bon fonctionnement de chacun des n composants de l'ensemble, chacun des n composants de l'ensemble présentant au moins une entrée de simulation apte à recevoir un signal de simulation de la défaillance ou du bon fonctionnement de ce composant, comprenant :

— un générateur (G) dont les sorties sont respectivement reliées aux entrées de simulation des composants, pour leur appliquer des signaux de simulation présentant un premier ou un second état logique permettant de mettre un ou plusieurs composants, respectivement en état de défaillance ou de bon fonctionnement, puis de remettre inversement et réciproquement ce ou ces composants, en état de bon fonctionnement ou de défaillance, pour une ou plusieurs combinaisons parmi les n composants de l'ensemble,

— des moyens de test (MT) reliés à la sortie de l'ensemble et capables de repérer le niveau logique du signal de sortie de l'ensemble, caractérisé en ce que les moyens de test comprennent :

— un compteur (CPR) ayant une entrée de chargement d'une valeur prédéterminée correspondant aux nombres de composants à simuler dans le circuit testé, ce compteur ayant une autre entrée qui est reliée à la sortie du générateur fournissant un signal d'initialisation (INIT) à l'initialisation du générateur, et une autre entrée qui est reliée à une sortie du générateur pour recevoir une impulsion de commande (CL), cette impulsion commandant le décomptage de ce compteur, une sortie de ce compteur (CPR) étant reliée à une entrée de commande d'arrêt du générateur pour arrêter ce générateur lorsque tous les composants ont été simulés,

— un autre compteur (CPL) relié à une sortie du générateur pour recevoir un signal (RAZL) de remise à 0, à l'initialisation du générateur et une autre entrée qui est reliée à la sortie du générateur qui fournit chaque impulsion de commande (CL), cette impulsion commandant l'incrémentation du contenu du compteur,

— des moyens de repérage (ET₈, 36) du niveau logique du signal de sortie de l'ensemble, ces moyens de repérage étant reliés à la sortie de l'ensemble et à une sortie du générateur fournissant un signal de synchronisation (SYNC) pour chaque nouvelle combinaison de signaux de simulation, et à une sortie dudit autre compteur (CPL) pour repérer le numéro de tout composant pour lequel le changement de niveau logique du signal de simulation qui lui est appliqué provoque un changement de niveau du signal de sortie de l'ensemble.

2. Système de test selon la revendication 1, caractérisé en ce que les moyens de repérage comprennent une porte ET (ET₈) ayant une entrée inversée (32) reliée à la sortie de l'ensemble, et une autre entrée reliée à la sortie du générateur qui fournit ledit signal (SYNC) de synchronisation, et un moyen d'affichage (36) de numéros dont une entrée est reliée à la sortie de la porte ET (ET₈) et dont une autre entrée est reliée à la sortie dudit autre compteur (CPL).

3. Système de test selon la revendication 2, caractérisé en ce que dans un ensemble de composants pour lesquels le générateur (G) fournit des signaux dont le niveau logique correspond à la défaillance de ces composants et pour lesquels le signal de sortie de l'ensemble présente un niveau logique correspondant à la défaillance de cet ensemble, ce générateur fournissant ensuite successivement à chaque composant un signal dont le niveau logique correspond à son bon fonctionnement, les moyens d'affichage (36) indiquent le ou les numéros des composants dits critiques pour lesquels la simulation d'un bon fonctionnement provoque un changement du niveau du signal de sortie de l'ensemble, qui correspond alors au bon fonctionnement de l'ensemble.

4. Système de test selon la revendication 2, caractérisé en ce que dans un ensemble de composants pour lesquels le générateur (G) fournit des signaux dont le niveau logique correspond au bon fonctionnement de ces composants et pour lesquels le signal de sortie de l'ensemble présente un niveau logique correspondant au bon fonctionnement de cet ensemble, ce générateur fournissant ensuite successivement à chaque composant un signal dont le niveau logique correspond à sa défaillance, les moyens d'affichage (36) indiquent le ou les numéros des composants dits critiques pour lesquels la simultion d'une défaillance provoque un changement du niveau du signal de sortie de l'ensemble qui correspond alors à la défaillance de l'ensemble.

5. Système de test, selon la revendication 2, caractérisé en ce que dans un ensemble de composants pour lesquels le générateur (G) fournit à certains des composants des signaux dont le niveau logique correspond à la défaillance de ces composants et pour lesquels le signal de sortie de l'ensemble présente un niveau logique correspondant à la défaillance de cet ensemble, ce générateur fournissant ensuite à un ou d'autres composants de l'ensemble un signal dont le niveau logique correspond aussi à leur défaillance, les moyens d'affichage (36) indiquent le ou les numéros de ce ou ces autres composants dits non cohérents pour lesquels la simulation d'une défaillance provoque un changement du niveau du signal de sortie de l'ensemble qui correspond alors au bon fonctionnement de l'ensemble.

## Claims

1. System for testing the failure or satisfactory operation of a circuit (c) having logic components, in which n components form a system of components marked I to n in a predetermined manner and interconnected so that said system has on one output a logic state corresponding to the failure or satisfactory operation state of the system and which depends on the failure or satisfactory operating state of each of the n components of the system, each of the n components of the system having at least one simulation input able to receive a signal simulating the failure or satisfactory operation of said system, comprising :

— a generator (G) whose outputs are respectively connected to the simulation inputs of the components, in order to apply thereto simulation signals having a first or a second logic state making it possible to bring one or more components respectively into the failure or satisfactory operation state and then conversely and reciprocally bringing said component or components into a satisfactory operation or failure state, for one or more combinations from among the n components of the system ;

— testing means (MT) connected to the output of the system and able to mark the logic level of the output signal of the system ;

— characterized in that the test means comprise :

— a counter (CPR) having an input for loading a predetermined value corresponding to numbers of components to be simulated in the tested circuit, said counter having another input connected to the ouput of the generator supplying an initialization signal (INIT) on initializing the generator, and another input connected to an output of the generator for receiving a control pulse, the said pulse controlling the countdown of said counter (CPR), an output of said counter being connected to a stop control input of the generator for stopping the latter when all the components have been simulated ;

— another counter (CPL) connected to an output of the generator for receiving a resetting signal (RAZL), on initializing the generator and another input connected to the generator output and which supplies each control pulse (CL), said pulse controlling the incrementation of the counter content ;

— means (ET$_8$, 36) for making the logic level of the output signal of the system, said marking means being connected to the system output and to an output of the generator supplying a synchronizing signal (SYNC) for each new combination of simulation signals, and to an output of said other counter (CPL) for marking the number of any component for which the change of logic level of the simulation signal applied thereto brings about a change of level of the output signal of the system.

2. Testing system according to claim 1, characterized in that the marking means comprise an AND gate (ET$_8$) with an inverted input (32) connected to the output of the system, and another input connected to the output of the generator supplying said synchronizing signal (SYNC), and a number display means (36), whereof one input is connected to the output of the AND gate (ET$_8$) and whereof another input is connected to the output of said other counter (CPL).

3. Testing system according to claim 2, characterized in that in a system of components for which the generator (G) supplies signals, whose logic level corresponds to the failure of these components and for which the output signal of the system has a logic level corresponding to the failure of said system, said generator then successively supplying to each component a signal, whose logic level corresponds to its satisfactory operation, the display means (36) indicating the number of numbers of so-called critical components for which the simulation of a satisfactory operation brings about a change in the level of the output signal of the system, which then corresponds to the satisfactory operation of the system.

4. Testing system according to claim 2, characterized in that in a system of components for which the generator (G) supplies signals, whose logic level corresponds to the satisfactory operation of these components and for which the output signal of the system has a logic level corresponding to the satisfactory operation of said system, said generator then successively supplying to each component a signal, whose logic level corresponds to its failure, the display means (36) indicating the number or numbers of so-called critical components for which the simulation of a failure brings about a change in the level of the output signal of the system, which then corresponds to the failure of the system.

5. Testing system according to claim 2, characterized in that in a system of components for which the generator (G) supplies to certain of the components, signals whereof the logic level corresponds to the failure of these components and for which the output signal of the system has a logic level corresponding to the failure of said system, said generator then supplying to one or other components of the system, a signal whose logic level also corresponds to their failure, the display means (36) indicating the number or numbers of said incoherent other component or components for which the simulation of a failure brings about a change of level of the output signal of the system, which then corresponds to the satisfactory operation of the system.

**Patentansprüche**

1. System zum Testen des Gut- oder Schlechtfunktionierens eines Schaltkreises (C) aus logischen Bauteilen, in dem n Bauteile eine in vorgegebener Weise von 1 bis n numerierte Bauteilgesamtheit bilden und derart miteinander verbunden sind, daß die Gesamtheit an einem Ausgang einen logischen Zustand aufweist, der dem Gutfunktionieren oder Schlechtfunktionieren der Gesamtheit entspricht und der vom Zustand des Gutfunktionierens oder Schlechtfunktionierens eines jeden der n Bauteile der Gesamtheit abhängt, wobei jedes der n Bauteile der Gesamtheit wenigstens einen Simulationseingang aufweist zum Anlegen eines Simulationssignals für das Gutfunktionieren oder Schlechtfunktionieren dieses Bauteils, mit :

— einem Generator (G), dessen Ausgänge mit den entsprechenden Simulationseingängen der Bauteile verbunden sind, um ihnen die Simulationssignale zuzuführen, die den ersten oder den zweiten logischen Zustand darstellen, um so zu ermöglichen, daß eines oder mehrere der Bauteile den Zustand des Schlechtfunktionierens oder des Gutfunktionierens annehmen, um dann in umgekehrter Weise dieses oder diese Bauteile in den Zustand des Gutfunktionierens oder des Schlechtfunktionierens zu bringen und zwar eine oder mehrere Kombinationen unter den n Bauteilen der Gesamtheit,

— einer Testanordnung (MT), die mit dem Ausgang der Gesamtheit verbunden ist zur Feststellung des logischen Niveaus des Ausgangssignals der Gesamtheit, dadurch gekennzeichnet, daß die Testanordnung aufweist :

— einen Zähler (CPR) mit einem Ladeeingang für einen vorgegebenen Wert, der der Anzahl der zu simulierenden Bauteile im getesteten Schaltkreis entspricht, wobei dieser Zähler einen anderen Eingang aufweist, der mit dem Ausgang des Generators verbunden ist, der das Startsignal (INIT) für den Start des Generators liefert und einen anderen Eingang aufweist, der mit einem Ausgang des Generators verbunden ist, um einen Steuerimpuls (CL) zu empfangen, der das Abwärtszählen dieses Zählers steuert, wobei ein Ausgang des Zählers (CPR) mit einem Halt-Steuereingang des Generators verbunden ist, um diesen Generator anzuhalten, sofern alle Bauteile simuliert worden sind,

— einen weiteren Zähler (CPL), der mit einem Ausgang des Generators verbunden ist zur Aufnahme eines Rückstellsignals auf Null (RAZL) beim Start des Generators und mit einem anderen Eingang, der mit dem Ausgang des Generators verbunden ist, der jeden Steuerimpuls (CL) liefert, wobei dieser Impuls den Zuwachs des Inhalts des Zählers steuert,

— eine Numierungsanordnung (ET₈, 36) für das logische Niveau des Ausgangssignals der Gesamtheit, die mit dem Ausgang der Gesamtheit verbunden ist und mit einem Ausgang des Generators, der ein Synchronisationssignal (SYNC) liefert für jede neue Kombination von Simulationssignalen und mit einem Ausgang des anderen Zählers (CPL), um die Nummer eines jeden Bauteils zu markieren für das die Änderung des logischen Niveaus des angelegten Simulationssignals eine Änderung des Niveaus des Ausgangssignals der Gesamtheit bewirkt.

2. System zum Testen nach Anspruch 1, dadurch gekennzeichnet, daß die Anordnung zum Markieren ein UND-Tor (ET₈) aufweist mit einem invertierenden Eingang (32), der mit dem Ausgang der Gesamtheit verbunden ist und mit einem anderen Eingang, der mit dem Ausgang des Generators verbunden ist, welcher das Synchronisationssignal (SYNC) liefert und eine Anzeigenanordnung (36) für die Nummern aufweist, von dem ein Eingang mit dem Ausgang des UND-Tors (ET₈) verbunden ist und dessen anderer Eingang mit dem Ausgang des genannten anderen Zählers (CPL) verbunden ist.

3. System zum Testen nach Anspruch 2, dadurch gekennzeichnet, daß in einer Gesamtheit von Bauteilen, für die der Generator (G) Signale liefert, deren logisches Niveau dem Schlechtfunktionieren dieser Bauteile entspricht und für die das Ausgangssignal der Gesamtheit ein logisches Niveau aufweist, das dem Schlechtfunktionieren dieser Gesamtheit entspricht, der Generator anschliessend und aufeinanderfolgend einem jeden Bauteil ein Signal zuführt, dessen logisches Niveau seinem Gutfunktionieren entspricht und daß die Anzeigeanordnung (36) die Nummer oder die Nummern der kritischen Bauteile anzeigt für die die Simulation eines Gutfunktionierens eine Veränderung des Niveaus des Ausgangssignals der Gesamtheit bewirkt, die demzufolge dem Gutfunktionieren der Gesamtheit entspricht.

4. System zum Testen nach Anspruch 2, dadurch gekennzeichnet, daß in einer Gesamtheit von Bauteilen, für die der Generator (G) Signale liefert, deren logisches Niveau dem Gutfunktionieren dieser Bauteile entspricht und für die das Ausgangssignal der Gesamtheit ein logisches Niveau aufweist, das dem Gutfunktionieren der Gesamtheit-entspricht, dieser Generator anschließend und aufeinanderfolgend einem jeden Bauteil ein Signal zuführt, dessen logisches Niveau seinem Schlechtfunktionieren entspricht, wobei die Anzeigeanordnung (36) die Nummer oder die Nummern der kritischen Bauteile anzeigt, für die die Simulation eines Schlechtfunktionierens eine Veränderung des Niveaus des Ausgangssignals der Gesamtheit bewirkt, die demzufolge dem Schlechtfunktionieren der Gesamtheit entspricht.

5. System zum Testen nach Anspruch 2, dadurch gekennzeichnet, daß in einer Gesamtheit von Bauteilen, für die der Generator (G) an einige der Bauteile Signale zuführt, deren logisches Niveau dem Schlechtfunktionieren dieser Bauteile entspricht und für die das Ausgangssignal der Gesamtheit ein logisches Niveau aufweist, das dem Schlechtfunktionieren der Gesamtheit entspricht, dieser Generator anschließend einem oder mehreren Bauteilen der Gesamtheit ein Signal zuführt, dessen logisches Niveau ebenfalls ihrem Schlechtfunktionieren entspricht, wobei die Anzeigeanordnung (36) die Nummer oder die Nummern des oder der nicht kohärenten Bauteile anzeigt, für die die Simulation eines Schlechtfunktionierens eine Veränderung des Niveaus des Ausgangssignales der Gesamtheit bewirkt, die demzufolge dem Gutfunktionieren der Gesamtheit entspricht.

FIG.1A

FIG.1B

0=DEFAILLANCE

FIG.2A

0=DEFAILLANCE

FIG.2B

1= BON
FONCTIONNEMENT

FIG.2C

0=DEFAILLANCE

1

FIG. 3

FIG.4